# FASCICULE DE BREVET EUROPEEN

(11) **EP 3 136 302 B1**
(45) Date de publication et mention de la délivrance du brevet: **01.01.2020**
(21) Numéro de dépôt: 16185642.2
(22) Date de dépôt: 25.08.2016
(51) Int. Cl.: G06K 19/077

(54) **PROCÉDÉ DE FABRICATION D'UN CIRCUIT ÉLECTRIQUE, CIRCUIT ÉLECTRIQUE OBTENU PAR CE PROCÉDÉ ET CARTE À PUCE COMPORTANT UN TEL CIRCUIT ÉLECTRIQUE**
HERSTELLUNGSVERFAHREN EINES ELEKTRISCHEN SCHALTKREISES, MIT DIESEM VERFAHREN HERGESTELLTER ELEKTRISCHER SCHALTKREIS UND CHIPKARTE, DIE EINEN SOLCHEN SCHALTKREIS UMFASST
METHOD FOR PRODUCING AN ELECTRIC CIRCUIT, ELECTRIC CIRCUIT PRODUCED BY SAID METHOD AND SMART CARD COMPRISING SUCH AN ELECTRIC CIRCUIT

(30) Priorité: 27.08.2015 FR 1557974
(43) Date de publication de la demande: 01.03.2017
(73) Titulaire: Linxens Holding, 78200 Mantes-la-Jolie (FR)
(72) Inventeur: COPPOLA, Mara, 27000 EVREUX (FR); DE MAQUILLE, Yannick, 75016 PARIS (FR); MARCQ, Fabien, 63190 LEZOUX (FR)
(74) Mandataire: Regi, François-Xavier

(56) Documents cités:
- DE-A1- 19 523 242
- FR-A1- 2 777 506

## Description

L'invention concerne le domaine des circuits électriques, tels que des circuits imprimés. De tels circuits imprimés peuvent être, par exemple, flexibles et utilisés pour réaliser des modules électroniques pour carte à puce.

L'invention est illustrée ci-dessous en prenant l'exemple des modules électroniques pour cartes à puce, mais elle est facilement transposable à d'autres applications des circuits imprimés flexibles ou rigides.

Les cartes à puce sont bien connues du public, qui en a de multiples usages : cartes de crédit, cartes de transport, cartes d'identité, etc. Le document FR2777506A1 décrit des cartes à puce de ce type.

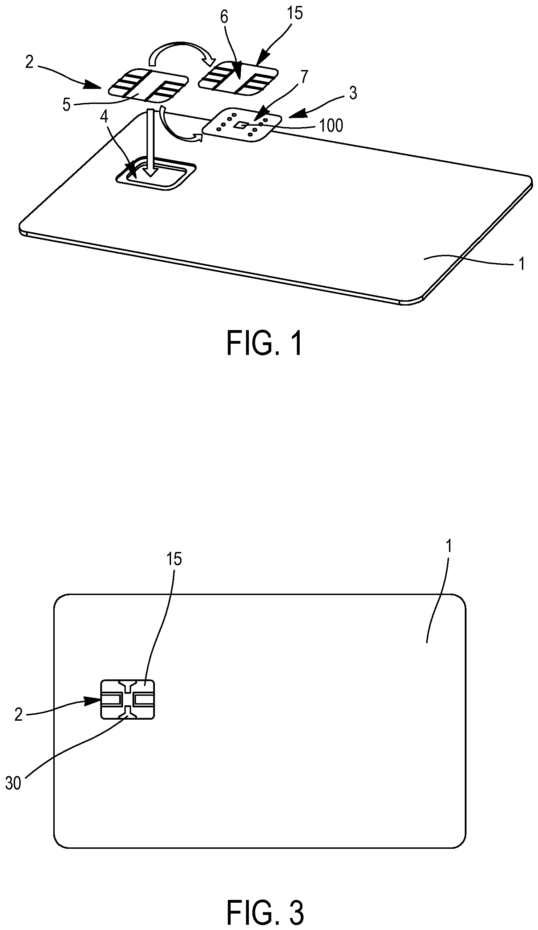

Comme représenté sur la figure 1, les cartes à puce sont généralement constituées d'un support rigide 1 en matière plastique de type PVC, PVC/ABS ou polycarbonate constituant l'essentiel de la carte, avec une cavité 4 dans laquelle est incorporé un module électronique 2 fabriqué séparément. Ce module électronique 2 comporte un circuit imprimé 3 généralement flexible muni d'une puce électronique 100 (circuit intégré) et de moyens de transmission pour transmettre des données de la puce à un dispositif lecteur de carte (lecture) ou de ce dispositif à la carte (écriture). Ces moyens de transmission de données peuvent être « à contact », « sans contact » ou bien « dual » lorsqu'ils combinent les deux moyens précédents. Dans une carte à puce « à contact », un connecteur 5 comporte des plages de contact 15 électriquement connectées à la puce 100 et affleurant, en surface du support de carte 1, pour une connexion par contact électrique avec un dispositif lecteur de carte. Dans une carte à puce « dual», en plus du connecteur 5, au moins une antenne est prévue, généralement dans le corps de carte, pour une connexion sans contact avec un dispositif lecteur de carte.

Dans l'art antérieur, les modules 2 de carte à puce sont généralement formés à partir d'un substrat diélectrique recouvert, sur au moins l'une de ses faces 6, 7, d'une feuille de matériau électriquement conducteur, constituée par exemple d'un métal tel que du cuivre, de l'acier ou de l'aluminium ou un alliage de l'un de ces métaux. Dans cette feuille de matériau électriquement conducteur sont réalisées des pistes conductrices formant, pour certaines au moins, les plages de contacts électriques 15. Les substrats diélectriques largement utilisés dans l'art antérieur sont réalisés en matériaux composites (verre-époxy) ou en matériaux plastiques (PET, PEN, polyimide, etc.). Ce type de substrat diélectrique est généralement mince (son épaisseur est par exemple de l'ordre de 100 µm) pour conserver une flexibilité compatible avec des procédés de fabrication des modules électroniques en continu.

Le procédé de fabrication de ce type de circuit électrique comprend alors par exemple :
- la fourniture d'une feuille de matériau électriquement conducteur, ayant donc une première et une deuxième face principales,
- la fourniture d'une couche de matériau adhésif,
- la mise en contact de l'une des faces principales de la couche de matériau électriquement conducteur avec la couche de matériau adhésif et
- la lamination de la feuille de matériau électriquement conducteur sur la couche de matériau adhésif.

Une couche de matériau diélectrique est généralement utilisée comme substrat, mais la couche de matériau adhésif peut, dans certaines conditions, être suffisante pour former elle-même un substrat diélectrique. Lorsqu'une couche de matériau diélectrique est utilisée, on procède à une étape d'enduction de l'une des faces principales de la couche de matériau diélectrique, avec le matériau adhésif, pour former la couche de matériau adhésif sur la couche de matériau diélectrique. La feuille de matériau électriquement conducteur est alors mise en contact avec la couche de matériau adhésif préalablement déposée sur la couche de matériau diélectrique, et l'ensemble ainsi formé est ensuite laminé.

Pour certaines applications et notamment pour réaliser des cartes à puce, il peut être intéressant d'obtenir une couleur visible dans des espaces découpés ou gravés dans la feuille de matériau électriquement conducteur. Cette couleur peut avoir purement une fonction esthétique, mais également masquer des éléments éventuellement disposés sous le module et qui seraient visibles en transparence entre les contacts ou autres motifs réalisés dans la feuille de matériau électriquement conducteur.

A cette fin il a été proposé d'utiliser un substrat diélectrique teinté, mais les fournisseurs de substrats, pour lesquels les substrats teintés ne correspondent pas nécessairement à leurs produits standards, sont réticents à multiplier le nombre de leurs produits pour augmenter la palette des couleurs à offrir à leurs clients. Le document DE19523242A1 décrit une solution avec un substrat teinté.

Un but de l'invention est de pallier cet inconvénient et de fournir un moyen simple d'obtenir de nombreuses possibilités de couleurs visibles entre au moins certaines zones découpées ou gravées dans la feuille de matériau électriquement conducteur.

Ainsi, il est proposé, selon l'invention, d'ajouter un agent colorant (colorant ou pigment) au matériau adhésif constitutif de la couche de matériau adhésif, pour former une couche de matériau adhésif teinté.

Dans ce document, on nomme
- « colorant » (« dye » en anglais), une matière soluble dans le milieu, c'est-à-dire ici le matériau adhésif, dans lequel il est introduit (on dit que un colorant est dissous dans le milieu) ;
- « pigment », une matière insoluble dans le milieu, c'est-à-dire ici le matériau adhésif, dans lequel il est introduit (on dit que un pigment est dispersé dans le milieu).

La couche d'adhésif teinté étant immédiatement sous-jacente à la feuille de matériau électriquement conducteur, sa couleur devient visible entre les zones découpées ou gravées dans celle-ci, par exemple entre des pistes conductrices, des contacts, des motifs formant des logos, etc.

Ce procédé n'ajoute pas réellement de modification du procédé de l'art antérieur. En effet, la couche de matériau adhésif est généralement nécessaire. En particulier, ce procédé est beaucoup plus simple qu'un procédé au cours duquel la couleur serait ajoutée, dans des espaces gravés dans la couche électriquement conductrice, après lamination et gravure de cette dernière.

Selon un autre aspect, l'invention concerne un circuit électrique comprenant une feuille de matériau électriquement conducteur, avec deux faces principales, et une couche de matériau adhésif en contact avec l'une des faces principales de la couche de matériau électriquement conducteur, un agent colorant étant ajouté au matériau adhésif constitutif de la couche de matériau adhésif, pour former une couche de matériau adhésif teinté.

Selon encore un autre aspect, l'invention concerne une carte à puce comportant un corps de carte et une cavité ménagée dans le corps de carte et dans laquelle est placé un module électronique comportant lui-même un circuit électrique, avec des contacts affleurant sur la surface du corps de carte, une couleur étant visible sur au moins une partie de la surface du module non-occupée par les contacts, cette couleur étant produite par un agent colorant présent dans une couche d'adhésif sous-jacente aux contacts et ajouté à un matériau adhésif pour former une couche de matériau adhésif teinté.

Le procédé, le circuit électrique ou la carte à puce selon l'invention comporte éventuellement l'une ou l'autre des caractéristiques mentionnées dans les revendications, considérées individuellement ou en combinaison.

D'autres caractéristiques et avantages de l'invention apparaîtront à la lecture de la description détaillée et des dessins annexés sur lesquels :
- La figure 1 représente schématiquement en perspective une carte à puce destinée à recevoir un module comprenant un circuit électrique ;
- Les figures 2a à 2l représentent schématiquement et successivement les différentes étapes d'un exemple de procédé de fabrication d'un circuit électrique ; et
- la figure 3 représente schématiquement, un exemple de carte avec un module obtenu par le procédé illustré par les figures 2a à 2l.

Un exemple de procédé de fabrication d'un circuit électrique selon l'invention est décrit ci-dessous. Il appartient au domaine de la carte à puce, mais comme cela a déjà été mentionné, des applications dans d'autres domaines (antennes RFID, LEDs, etc.) sont aisément transposables à partir de ce qui est décrit ici.

Comme représenté sur la figure 1, une carte à puce 1 comporte un module 2. Le module 2 comprend un circuit électrique flexible 3, muni d'un connecteur 5, et une puce 100. Le module 2 est généralement réalisé sous forme d'un élément séparé qui est inséré dans une cavité 4 ménagée dans la carte 1.

Le circuit électrique flexible 3 comporte donc un connecteur 5 avec plusieurs plages de contact 15 auxquelles est connectée la puce 100. Le circuit flexible 3 est représenté (en haut) vu par sa face avant 6 (face contact). Il est aussi représenté (en bas) vu par sa face arrière 7 ou face de liaison (« bonding » selon la terminologie anglo-saxonne). Le circuit électrique flexible 3 ainsi représenté correspond à un circuit électrique flexible simple face pour carte « à contact ». Mais il pourrait tout aussi bien s'agir d'un circuit électrique flexible double face, pour carte « dual » par exemple.

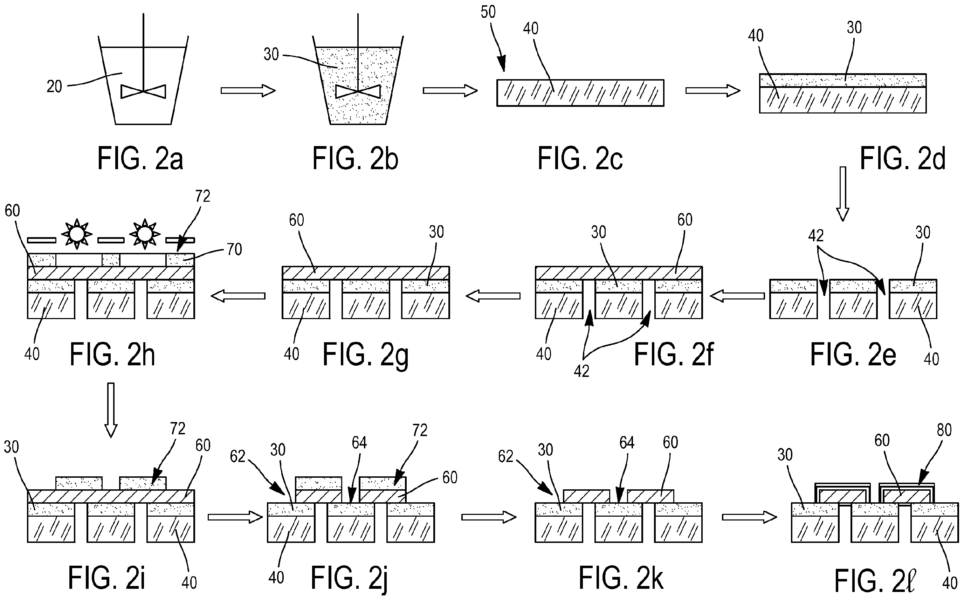

Les figures 2a à 2l illustrent schématiquement différentes étapes d'un exemple de procédé selon l'invention pour la fabrication du circuit électrique flexible 3.

Ce procédé comprend la fourniture (Fig. 2a) d'un matériau adhésif ou colle 20, sous forme liquide. Le matériau adhésif 20 est par exemple constitué d'epoxy, éventuellement modifiée. A ce stade, le matériau adhésif 20 est naturellement de couleur jaune clair et transparente.

A l'étape suivante (Fig. 2b), le matériau adhésif 20 pré-formulé est coloré par adjonction d'un agent colorant, colorant proprement dit ou pigment. Cet agent colorant peut teinter le matériau adhésif 20 par exemple en rouge, magenta, bleu, vert, orange, gris, noir, etc. On obtient un matériau adhésif teinté 30.

Des exemples de colorants sont mentionnés dans le tableau ci-dessous :

| **Agent colorant** | **Famille chimique** | **fournisseur** |
|---|---|---|
| Orasol® Red 365 | Complexe métallique | Basf® |
| Pylam® Solvent Red 24 Conc | disazo | Pylam® |
| Pylam® Magenta LX-7042 | Anthraquinone | Pylam® |
| Pylam® Blue LX-9699 | Phthalocyanine; Anthraquinone | Pylam® |
| Pylakrome Bright Green LX-10687 | Anthraquinone, Quinoline | Pylam® |
| Pylakrome Orange LX-10113 | azo | Pylam® |

Les concentrations utilisées pour les colorants varient entre 0,5 et 5 phr (« phr » signifiant «parts per hundred resin », c'est-à-dire entre 0,5 et 5 pourcents en masse d'agent colorant, par rapport au(x) résine(s) solide(s) (donc sans les solvants) présente(s) dans le matériau adhésif 20.

L'agent colorant peut aussi être un pigment. Il peut alors s'agir d'un pigment (ou d'un mélange de plusieurs pigments) en poudre ou en pré-dispersion pigmentaire (également avec un ou plusieurs pigments).

Les pigments en poudre sont à disperser dans un milieu. Leur concentration dans le milieu est par exemple comprise entre 0,5 et 5 phr.

Les pré-dispersions pigmentaires se présentent sous forme de produits contenant des résines et/ou des solvants, un ou plusieurs pigments, ainsi que d'éventuels agents dispersants, additifs, etc. La composition de ces pré-dispersions pigmentaires varie selon le produit lui-même et/ou son fabriquant. Les pré-dispersions pigmentaires sont faciles d'utilisation car il faut juste les mélanger au matériau adhésif. La concentration des pigments dans les pré-dispersions pigmentaires peuvent être très variées : par exemple de 10% à 70% en poids de pigment dans la pré-dispersion pigmentaire.

Chromaflo est par exemple un fournisseur de pré-dispersions pigmentaires. La référence Temacolor™ EP RM15 de Chromaflo est une pré-dispersion pigmentaire rouge. Utilisée avec une concentration de 20 phr, elle donne de bons résultats, sans dégrader les propriétés du matériau adhésif. D'une manière plus générale, on peut faire varier la concentration de pré-dispersion pigmentaire dans le matériau adhésif de 1 à 50 phr (voire plus).

D'autres exemples de pigments et de pré-dispersions pigmentaires sont indiqués dans le tableau ci-dessous :

| **Fournisseur** | **Nom du produit** | **Etat physique** | **Color Index (C.I.)** | **chimie** |
|---|---|---|---|---|
| **BASF®** | Orasol® Microlith 3630K | Pigment en poudre | Red 254 | Diketopyrrolopyrrole pré-dispersé dans une résine copolymère de vinyle |
| **Chromaflo™** | Temacolor™ EP RM15 | pré-dispersion pigmentaire | Red 254 | Diketopyrrolopyrrole pré-dispersé dans une résine epoxy liquide |
| | Temacolor™ EP BM15 | | Blue 15:3 | Phtalocyanine de cuivre pré-dispersée dans une résine epoxy liquide |
| **Protec®** | DecoTint® Premium I Red 644 RB | pré-dispersion pigmentaire | Red 254 | Diketopyrrolopyrrole pré-dispersé dans une résine PGMA à base de solvant |
| | DecoTint® Premium I Blue 675 BR | | Blue 15:4 | Phtalocyanine de cuivre pré-dispersée dans une résine PGMA à base de solvant |
| **Clariant(via Univar®)** | Hostatint Red A-P2Y 100-ST | pré-dispersion pigmentaire | Red 179 | Perylene pré-dispersé dans un solvant dibasique ester |
| | Hostatint Blue A-BTR 100-ST | | Blue 15:1 | Phtalocyanine de cuivre pré-dispersée dans un solvant dibasique ester |
| **Trustchem** | Pigment Red 254 | Pigment en poudre | Red 254 | Diketopyrrolopyrrole |
| | Pigment Red 122 | | Red 122 | Quinacridone |
| | Pigment Blue 60 | | Blue 60 | Anthraquinone |

On fournit une couche de matériau diélectrique 40, pour former un substrat 50 (Fig. 2c). Ce matériau diélectrique 40 est par exemple du verre-epoxy. Ce matériau diélectrique 40 peut être de couleur grise, jaune ou blanc par exemple. Son épaisseur est par exemple voisine de 100µm.

La couche de matériau diélectrique 40 est ensuite enduite (Fig. 2d) avec le matériau adhésif teinté 30 obtenu à l'étape correspondant à la figure 2b. La couche de matériau adhésif 40 a, par exemple, une épaisseur comprise entre 10 et 70µm après séchage, et plus préférentiellement entre 10 et 50µm après séchage, par exemple elle a une épaisseur de 18µm, à 3µm près.

Après séchage, l'ensemble constitué de la couche de matériau diélectrique 40 et du matériau adhésif teinté 30 est perforé de part en part (Fig. 2e), par exemple mécaniquement par poinçonnage, pour former des trous 42 correspondant à des puits de connexion et éventuellement des ouvertures pour recevoir un ou plusieurs composants électroniques.

Une feuille de matériau électriquement conducteur 60 est mise au contact de la couche de matériau adhésif 30 (Fig. 2f). La feuille de matériau électriquement conducteur 60 recouvre les trous 42. L'ensemble constitué de la feuille de matériau électriquement conducteur 60, de la couche de matériau adhésif teinté 30 et de la couche de matériau diélectrique 40 est laminé. La couche de matériau adhésif teinté 30 est réticulée en étuve (Fig. 2g).

Des motifs en résine 72 sont réalisés par photolithographie sur la feuille de matériau électriquement conducteur 60, par dépôt, insolation (Fig. 2h) et révélation d'une résine photosensible 70 (Fig. 2i).

Une étape de gravure de motifs par voie électrochimique permet de réaliser des motifs 62 dans la feuille de matériau électriquement conducteur 60 (Fig. 2j). Des espaces 64 entre les différents éléments des motifs 62 (contacts, logos, etc.) sont gravés dans la feuille de matériau électriquement conducteur 60 et la couche de matériau adhésif teinté 30 est apparente entre ces espaces 64.

La résine protégeant les motifs 62 pendant la gravure est retirée (Fig. 2k) et des couches de finition 80 (Nickel et Or par exemple), sont éventuellement déposées sur la face avant 6 par électrodéposition sur au moins une partie des motifs 62 (Fig. 2l).

Au cours d'étapes non-illustrées, une puce est fixée en face arrière de chaque module. Chaque puce est connectée, par exemple par des fils conducteurs, à travers des puits de connexion (comme les trous 42), au fond de ceux-ci, à des contacts 15. La puce et les fils conducteurs sont encapsulés et les modules sont individualisés et reportés, chacun individuellement dans une cavité de carte. Le résultat est reproduit sur la figure 3. La couleur du matériau adhésif teinté 30 est visible entre les contacts 15.

De nombreuses variantes du procédé décrit ci-dessus peuvent être envisagées. Par exemple :
- le procédé est mis en œuvre sur un circuit double face, au lieu du circuit simple face de la figure 2l ; le circuit comporte alors une feuille de matériau conducteur sur chacune des deux faces opposées de la couche de matériau diélectrique; dans ce cas, la feuille de matériau conducteur sur l'une des faces peut correspondre à celle d'un stratifié cuivré (« copper clad » selon la terminologie anglo-saxonne) avec un substrat diélectrique de verre-epoxy par exemple ; et/ou
- au lieu de graver la feuille de matériau conducteur 60 après l'avoir laminée sur la couche de matériau diélectrique 40, les motifs 62 sont découpés dans une feuille de matériau conducteur 60, avant d'être reportés sur la couche de matériau diélectrique 40 (technologie des grilles conductrices, aussi appelée « leadframe » selon la terminologie anglo-saxonne).

## Revendications

1. Procédé de fabrication d'un circuit électrique (3) destiné à connecter une puce électronique à une couche conductrice, comprenant :
- la fourniture d'une couche de matériau diélectrique ayant deux faces principales pour former un substrat,
- la fourniture d'une feuille de matériau électriquement conducteur (60), avec deux faces principales,
- la réalisation d'un motif de circuit électrique dans la feuille de matériau électriquement conducteur,
- la fourniture d'une couche de matériau adhésif (20),
- la mise en contact de l'une des faces principales de la feuille de matériau électriquement conducteur (60) avec la couche de matériau adhésif (20) et
- la lamination de la feuille de matériau diélectrique, de la feuille de matériau électriquement conducteur (60) et de la couche de matériau adhésif (20),
**caractérisé par le fait qu'**un agent colorant est ajouté au matériau adhésif constitutif de la couche de matériau adhésif (20), pour former une couche de matériau adhésif teinté (30).

2. Procédé selon la revendication 1, dans lequel des zones sont découpées ou gravées dans la feuille de matériau électriquement conducteur (60), entre lesquelles la couche de matériau adhésif teinté (30) est visible.

3. Procédé selon la revendication 1 ou 2, comprenant une étape d'enduction de l'une des faces principales de la couche de matériau diélectrique (40), avec le matériau adhésif teinté (30), sur la couche de matériau diélectrique (40), avant la mise en contact de l'une des faces principales de la couche de matériau électriquement conducteur (60) avec la couche de matériau adhésif teinté (30) déposée sur la couche de matériau diélectrique (40) et la lamination de la feuille de matériau électriquement conducteur (60) avec la couche de matériau diélectrique (40).

4. Procédé selon l'une des revendications précédentes, dans lequel l'agent colorant est un colorant, un pigment en poudre ou une pré-dispersion pigmentaire.

5. Procédé selon l'une des revendications précédentes, dans lequel l'agent colorant représente entre 0,5 et 50 unités par centaine de résine (parts per hundred of resin phr) du matériau adhésif.

6. Procédé selon l'une des revendications précédentes, dans lequel l'agent colorant appartient à au moins l'une des familles de composés chimiques de la liste constituée des complexes de métaux, des Disazos, des Azos, des Anthraquinones, des Diketopyrrolopyrroles, Phtalocyanines, des Pérylènes, des Quinacridone, et des Quinolines.

7. Procédé selon l'une des revendications précédentes, comprenant une étape de réalisation de contacts (15) dans la feuille de matériau électriquement conducteur (60).

8. Procédé selon la revendication 7, dans lequel les contacts (15) sont gravés par gravure électro-chimique dans la feuille de matériau électriquement conducteur (60).

9. Circuit électrique obtenu selon le procédé de l'une des revendications 1 à 8, ledit circuit électrique comprenant une feuille de matériau électriquement conducteur (60), avec deux faces principales, un motif de circuit électrique dans la feuille de matériau électriquement conducteur et une couche de matériau adhésif (20) en contact avec l'une des faces principales de la couche de matériau électriquement conducteur (60),
**caractérisé par le fait qu'**un agent colorant est ajouté au matériau adhésif constitutif de la couche de matériau adhésif (20), pour former une couche de matériau adhésif teinté (30).

10. Circuit électrique selon la revendication 9, comprenant des zones découpées ou gravées dans la feuille de matériau électriquement conducteur (60), entre lesquelles la couche de matériau adhésif teinté (30) est visible.

11. Circuit électrique selon la revendication 9 ou 10, comprenant en outre une couche de matériau diélectrique (40), la couche de matériau adhésif teinté (30) étant placée entre la couche de matériau diélectrique (40) et la feuille de matériau électriquement conducteur (60) et maintenant la couche de matériau diélectrique (40) et la feuille de matériau électriquement conducteur (60) adhérées l'une à l'autre.

12. Circuit électrique selon l'une des revendications 9 à 11, dans lequel l'agent colorant représente entre 0,5 et 50 unités par centaine de résine (parts per hundred of resin phr) du matériau adhésif.

13. Circuit électrique selon l'une des revendications 9 à 12, dans lequel l'agent colorant appartient à au moins l'une des familles de composés chimiques de la liste constituée des complexes de métaux, des Disazos, des Azos, des Anthraquinones, des Diketopyrrolopyrroles, Phtalocyanines, des Pérylènes, des Quinacridone, et des Quinolines.

14. Carte à puce comportant un corps de carte (1) et une cavité (4) ménagée dans le corps de carte et dans laquelle est placé un module électronique (2) comportant un circuit électrique (3) selon l'une des revendications 9 à 13, le module électronique (2) comportant des contacts (15) affleurant sur la surface du corps de carte (1) et une couleur étant visible sur au moins une partie de la surface du module (2) non-occupée par les contacts (15), cette couleur étant produite par un agent colorant présent dans une couche d'adhésif sous-jacente aux contacts (15) et ajouté à un matériau adhésif pour former une couche de matériau adhésif teinté (30).

## Patentansprüche

1. Verfahren zur Herstellung eines elektrischen Schaltkreises (3), der dazu bestimmt ist, einen elektronischen Chip mit einer leitenden Schicht zu verbinden, umfassend:
- das Bereitstellen einer Schicht aus dielektrischem Material mit zwei Hauptseiten, um ein Substrat zu bilden,
- das Bereitstellen einer Folie aus elektrisch leitendem Material (60) mit zwei Hauptseiten,
- das Ausführen eines Musters eines elektrischen Schaltkreises in der Folie aus elektrisch leitendem Material,
- das Bereitstellen einer Schicht aus klebendem Material (20),
- das Inkontaktbringen der einen der Hauptseiten der Folie aus elektrisch leitendem Material (60) mit der Schicht aus klebendem Material (20) und
- das Laminieren der Folie aus dielektrischem Material, der Folie aus elektrisch leitendem Material (60) und der Schicht aus klebendem Material (20),
**dadurch gekennzeichnet, dass** dem klebenden Material, aus dem die Schicht aus klebendem Material (20) besteht, ein Farbstoff zugegeben wird, um eine Schicht aus gefärbtem klebendem Material (30) zu bilden.

2. Verfahren nach Anspruch 1, bei dem Bereiche in der Folie aus elektrisch leitendem Material (60) ausgeschnitten oder geätzt werden, zwischen denen die Schicht aus gefärbtem klebendem Material (30) sichtbar ist.

3. Verfahren nach Anspruch 1 oder 2, umfassend einen Schritt des Überziehens der einen der Hauptseiten der Schicht aus dielektrischem Material (40) mit dem gefärbten klebenden Material (30) auf der Schicht aus dielektrischem Material (40) vor dem Inkontaktbringen der einen der Hauptseiten der Schicht aus elektrisch leitenden Material (60) mit der Schicht aus gefärbtem klebendem Material (30), die auf die Schicht aus dielektrischem Material (40) aufgebracht ist, und dem Laminieren der Folie aus elektrisch leitendem Material (60) mit der Schicht aus dielektrischem Material (40).

4. Verfahren nach einem der vorhergehenden Ansprüche, bei dem der Farbstoff ein Farbmittel, ein pulverförmiges Pigment oder eine Pigment-Vordispersion ist.

5. Verfahren nach einem der vorhergehenden Ansprüche, bei dem der Farbstoff zwischen 0,5 und 50 Einheiten je hundert Einheiten Harz (parts per hundred of resin phr) des klebenden Materials ausmacht.

6. Verfahren nach einem der vorhergehenden Ansprüche, bei dem der Farbstoff mindestens einer der Familien chemischer Verbindungen der Liste angehört, die aus Metallkomplexen, Disazofarbstoffen, Azofarbstoffen, Anthrachinonen, Diketopyrrolopyrrolen, Phthalocyaninen, Perylenen, Chinacridonen und Chinolinen besteht.

7. Verfahren nach einem der vorhergehenden Ansprüche, umfassend einen Schritt des Ausführens von Kontakten (15) in der Folie aus elektrisch leitendem Material (60).

8. Verfahren nach Anspruch 7, bei dem die Kontakte (15) durch elektrochemisches Ätzen in die Folie aus elektrisch leitendem Material (60) geätzt werden.

9. Elektrischer Schaltkreis, der nach dem Verfahren eines der Ansprüche 1 bis 8 erhalten wird, wobei der elektrische Schaltkreis eine Folie aus elektrisch leitendem Material (60) mit zwei Hauptseiten, ein Muster eines elektrischen Schaltkreises in der Folie aus elektrisch leitendem Material und eine Schicht aus klebendem Material (20) in Kontakt mit einer der Hauptseiten der Schicht aus elektrisch leitenden Material (60) umfasst,
**dadurch gekennzeichnet, dass** dem klebenden Material, aus dem die Schicht aus klebendem Material (20) besteht, ein Farbstoff zugegeben wird, um eine Schicht aus gefärbtem klebendem Material (30) zu bilden.

10. Elektrischer Schaltkreis nach Anspruch 9, umfassend Bereiche, die in der Folie aus elektrisch leitendem Material (60) ausgeschnitten oder geätzt sind, zwischen denen die Schicht aus gefärbtem klebendem Material (30) sichtbar ist.

11. Elektrischer Schaltkreis nach Anspruch 9 oder 10, umfassend ferner eine Schicht aus dielektrischem Material (40), wobei die Schicht aus gefärbtem klebendem Material (30) zwischen der Schicht aus dielektrischem Material (40) und der Folie aus elektrisch leitendem Material (60) angeordnet ist und die Schicht aus dielektrischem Material (40) und die Folie aus elektrisch leitendem Material (60) miteinander verklebt.

12. Elektrischer Schaltkreis nach einem der Ansprüche 9 bis 11, bei dem der Farbstoff zwischen 0,5 und 50 Einheiten je hundert Einheiten Harz (parts per hundred of resin phr) des klebenden Materials ausmacht.

13. Elektrischer Schaltkreis nach einem der Ansprüche 9 bis 12, bei dem der Farbstoff mindestens einer der Familien chemischer Verbindungen der Liste angehört, die aus Metallkomplexen, Disazofarbstoffen, Azofarbstoffen, Anthrachinonen, Diketopyrrolopyrrolen, Phthalocyaninen, Perylenen, Chinacridonen und Chinolinen besteht.

14. Chipkarte, umfassend einen Kartenkörper (1) und eine Vertiefung (4), die in dem Kartenkörper ausgebildet und in der ein elektronisches Modul (2) platziert wird, das einen elektrischen Schaltkreis (3) nach einem der Ansprüche 9 bis 13 umfasst, wobei das elektronische Modul (2) Kontakte (15) umfasst, die mit der Oberfläche des Kartenkörpers (1) bündig sind, und eine Farbe auf mindestens einem Teil der Oberfläche des Moduls (2), die nicht von den Kontakten (15) eingenommen wird, sichtbar ist, wobei diese Farbe von einem Farbstoff erzeugt wird, der in einer unter den Kontakten (15) liegenden klebenden Schicht vorhanden ist und einem klebenden Material zugegeben wird, um eine Schicht aus gefärbtem klebendem Material (30) zu bilden.

## Claims

1. Method for manufacturing an electrical circuit board (3) intended to connect an electronic chip to a conductive layer, comprising:
- the provision of a layer of dielectric material having two main sides to form a substrate;
- the provision of a sheet of electrically conductive material (60), with two main sides;
- the formation of an electrical circuit pattern in the sheet of electrically conductive material;
- the provision of a layer of adhesive material (20);
- the placing in contact of one of the main sides of the layer of electrically conductive material (60) with the layer of adhesive material (20); and
- the lamination of the sheet of dielectric material, the sheet of electrically conductive material (60) and the layer of adhesive material (20),
**characterized in that** a colouring agent is added to the adhesive material forming the layer of adhesive material (20), in order to form a layer of dyed adhesive material (30).

2. Method according to Claim 1, in which zones are cut out of or etched into the sheet of electrically conductive material (60), between which the layer of dyed adhesive material (30) is visible.

3. Method according to Claim 1 or 2, comprising a step of coating one of the main sides of the layer of dielectric material (40) with the dyed adhesive material (30) on the layer of dielectric material (40) before placing one of the main sides of the electrically conductive material (60) in contact with the layer of dyed adhesive material (30) that is deposited on the layer of dielectric material (40), and laminating the sheet of electrically conductive material (60) with the layer of dielectric material (40).

4. Method according to one of the preceding claims, in which the colouring agent is a dye, a powdered pigment or a pre-dispersed pigment.

5. Method according to one of the preceding claims, in which the colouring agent represents between 0.5 and 50 parts per hundred of resin (phr) of the adhesive material.

6. Method according to one of the preceding claims, in which the colouring agent belongs to at least one of the families of chemical compounds from the list composed of metal complexes, diazos, azos, anthraquinones, diketopyrrolopyrroles, phthalocyanines, perylenes, quinacridones, and quinolines.

7. Method according to one of the preceding claims, comprising a step of producing contacts (15) in the sheet of electrically conductive material (60).

8. Method according to Claim 7, in which the contacts (15) are etched into the sheet of electrically conductive material (60) by electrochemical etching.

9. Electrical circuit board obtained according to the method of one of Claims 1 to 8, said electrical circuit board comprising a sheet of electrically conductive material (60), with two main sides, an electrical circuit pattern in the sheet of electrically conductive material and a layer of adhesive material (20) in contact with one of the main sides of the layer of electrically conductive material (60),
**characterized in that** a colouring agent is added to the adhesive material forming the layer of adhesive material (20), in order to form a layer of dyed adhesive material (30).

10. Electrical circuit board according to Claim 9, comprising zones that are cut out of or etched into the sheet of electrically conductive material (60), between which the layer of dyed adhesive material (30) is visible.

11. Electrical circuit board according to Claim 9 or 10, additionally comprising a layer of dielectric material (40), the layer of dyed adhesive material (30) being placed between the layer of dielectric material (40) and the sheet of electrically conductive material (60) and maintaining adhesion between the layer of dielectric material (40) and the sheet of electrically conductive material (60).

12. Electrical circuit board according to one of Claims 9 to 11, in which the colouring agent represents between 0.5 and 50 parts per hundred of resin (phr) of the adhesive material.

13. Electrical circuit board according to one of Claims 9 to 12, in which the colouring agent belongs to at least one of the families of chemical compounds from the list composed of metal complexes, diazos, azos, anthraquinones, diketopyrrolopyrroles, phthalocyanines, perylenes, quinacridones, and quinolines.

14. Chip card comprising a card body (1) and a cavity (4) made in the card body and in which an electronic module (2), comprising an electrical circuit board (3) according to one of Claims 9 to 13, is placed, the electronic module (2) comprising contacts (15) flush with the surface of the card body (1) and a colour that is visible on at least a portion of the surface of the module (2) not occupied by the contacts (15), this colour being produced by a colouring agent present in a layer of adhesive subjacent to the contacts (15) and added to an adhesive material in order to form a layer of dyed adhesive material (30).
